# EUROPEAN PATENT SPECIFICATION

(11) **EP 0 420 323 B1**
(45) Date of publication and mention of the grant of the patent: **14.09.1994**
(21) Application number: 90202457.9
(22) Date of filing: 17.09.1990
(51) Int. Cl.: H01R 13/658

(54) **Filter connector with latchable monting frame**
Filterverbinder mit verriegelbarem Einbaurahmen
Connecteur à filtre avec embase verrouillable

(30) Priority: 29.09.1989 NL 8902429
(43) Date of publication of application: 03.04.1991
(73) Proprietor: CONNECTOR SYSTEMS TECHNOLOGY N.V., Willemstad, Curaçao (AN); DU PONT DE NEMOURS (NEDERLAND) B.V., 3300 AC Dordrecht (NL)
(72) Inventor: Thelissen, Guillaume Francois Gustave, NL-5233 RG 's-Hertogenbosch (NL)
(74) Representative: de Bruijn, Leendert C.

(56) References cited:
- DE-U- 8 715 632
- FR-A- 2 283 564
- US-A- 3 530 426
- US-A- 4 212 510

## Description

The invention relates to a filter connector with latchable mounting frame for mounting on a metal chassis of an electrical apparatus.

Electronic circuits for use in, for example, motor vehicles shave to meet high standards as regards shielding against interference signals. The interference signals produced in an automobile while it is running extend over a broad frequency range, i.e. from a few Hz to several MHz. Filter connectors are commonly used in motor vehicles to suppress interference signals which occur between interconnections of various electronic units.

Dutch patent application 88.01570, published January 16, 1990 (not a prior publication) in the name of applicant, describes a filter connector with a filter unit comprising a flat substrate having filter capacitors which suppress interference signals of relatively high frequency. An effective shielding against interference signals of relatively low frequency is achieved by mounting the substrate with one flat side thereof directly in contact with the grounding chassis. This is accomplished through the use of a holder or mounting frame of electrically conducting material which engages the other flat side of the substrate. Said frame has mounting lips which can be bent over to secure it to the chassis. The chassis is formed of two dish-shaped shells of sheet metal between which electronic components are disposed for shielding against interference signals.

For effective shielding against interference signals, it is desirable for the filter unit substrate to be in electrical contact with the chassis to which it is mounted along its entire periphery of the filter unit substrate, i.e. the common electrode of the filter elements which is electrically connectable near the periphery of the substrate. When the chassis is formed of sheet metal, this is generally easy to achieve since the surface of sheet metal can be formed with sufficient accuracy by means of pressing or punching. A high surface accuracy is important to avoid undesirable mechanical stresses on the filter substrate when it is mounted. This is particularly important in the case of substrates of ceramic material, such as alumina, which are generally fairly brittle and are thus susceptible to cracks and breakage.

One or more of the above-mentioned filter connectors are used in, for example, car telephones for the electric coupling between the transmitter and receiver parts, which are fitted in separate, shielded compartments. In the case of such car telephones, cast aluminium parts are, however, used as the chassis. Since all openings and mounting faces are made by casting, a machine finishing of the mounting faces to obtain a desired surface accuracy for mounting filter connectors is too expensive in practice. Mounting the filter unit subtrate in direct contact with the chassis is therefore considerably more difficult when a cast metal chassis is used.

On the other hand a mounting frame according to the preamble of Claim 8 is known from US-A-4 212 510.

The object of the invention is now to provide a filter connector with a mounting frame for mounting in the opening provided for it in a metal chassis without the need for a finishing operation on the surface of the chassis or the need for screw fastenings and the like.

According to the invention there is provided a filter connector with latchable mounting frame for mounting on a metal chassis of an electrical apparatus, comprising a filter unit formed of a flat substrate of electrically insulating material having a plurality of contact elements of electrically conducting material which project relative to the plane of the substrate, and filter elements formed on the substrate having one or more separate electrode patches connected to the respective contact elements and at least one common electrode which can be connected near at least one of the edges of the substrate, wherein the mounting frame is of electrically conducting material having a flat baseplate with a feed-through aperture through which the contact elements extend, said substrate rests with one side adjacent one side of the baseplate, the at least one common electrode being in electrical contact with the mounting frame, at the other side of its baseplate the mounting frame being provided with resilient mounting lips which project relative to the plane of the baseplate for releasably latch and electrically connect the filter connector in a self-latching manner on the chassis, in an opening for the contact elements.

The mounting lips here fulfil a twofold function, namely absorbing any height differences in the surface of the chassis near the opening for mounting the filter connector, and producing electrical contact between the frame and the chassis. When mounted, the filter substrate rests with one flat side on the said one flat side of the baseplate of the mounting frame. This flat side of the baseplate can generally easily be formed with a surface accuracy which is desired for achieving the necessary electrical and mechanical contact between the substrate and the mounting frame, by producing the latter of sheet metal by means of pressing or punching, for example.

An embodiment of the filter connector according to the invention which is advantageous as regards mounting is characterized in that at their projecting free end the mounting lips are in a form which is bent over backwards for the clamped accommodation of a part of the chassis between the said other side of the baseplate and the backward bent end of the mounting lips.

A filter connector designed in this way is mounted simply by placing the mounting frame with the mounting lips at one side of the chassis in front of the appropriate opening therein. By subjecting the frame to a pressure force in the direction of the opening, the mounting lips will tilt slightly and pass through the opening, and will then return under the influence of their own resilience to their initial position, in which the bent back ends of the mounting lips in question act upon the other side of the chassis. This produces a sturdy, self-latching, clamping fixing of the filter connector on the chassis. The filter connector with its mounting frame can easily be removed from the chassis again by moving the lips by hand, for example.

Although the mounting lips can extend over the entire periphery of the mounting frame, it has been found that a fastening which is sufficiently mechanically stable for many purposes is obtained if the mounting lips are disposed near at least two opposite boundary edges of the feed-through aperture.

An embodiment of the filter connector which is particularly advantageous to manufacture has mounting lips which are integral with the mounting frame and are formed from the material of the baseplate at the feed-through aperture. The mounting lips in question can be obtained by, for example, punching out of the baseplate. The opening so made in the baseplate provides the feed-through aperture for the contact elements of the filter connector.

The baseplate of the mounting frame must not go askew during fitting due to height or thickness differences of the chassis near the opening for accommodating the filter connector. This is detrimental to the electrical connection of the filter unit substrate to the mounting frame and could cause undesirable mechanical stresses to be exerted on the substrate. This is prevented in a further embodiment of the invention wherein the feed-through aperture is formed by slot-type apertures which are situated corresponding to the pitch distance of the contact elements, the mounting lips extending alternately from one and the other boundary edge of the feed-through aperture.

It will be clear that the baseplate in this embodiment is mechanically sturdier than in an embodiment in which the baseplate is provided with a single feed-through aperture extending over the distance of the contact elements.

In yet another embodiment of the filter connector according to the invention the baseplate of the mounting frame is provided with edges projecting at right angles to the said one side thereof, for the accommodation of the substrate between them. Such raised sides have a beneficial effect on the mechanical rigidity of the mounting frame.

The invention also relates to a mounting frame of the type described above. The use of such a mounting frame is, of course, not necessarily limited to substrates provided with filter elements, but it can be used for easy and efficient mounting of any connector of this type.

The invention is explained in greater detail below with reference to a preferred embodiment of the filter connector shown in the drawing.
Fig. 1 shows schematically in perspective a part of a cast metal housing, with apertures for the accommodation of filter connectors, and a filter connector in assembled and unassembled state;
Fig. 2 shows schematically in perspective, on an enlarged scale, a part of the mounting frame of the filter connector according to the invention;
Fig. 3 shows schematically in cross-section a filter connector according to the invention, mounted on a chassis.
Fig. 4 shows schematically the filter unit substrate of figs. and 2.

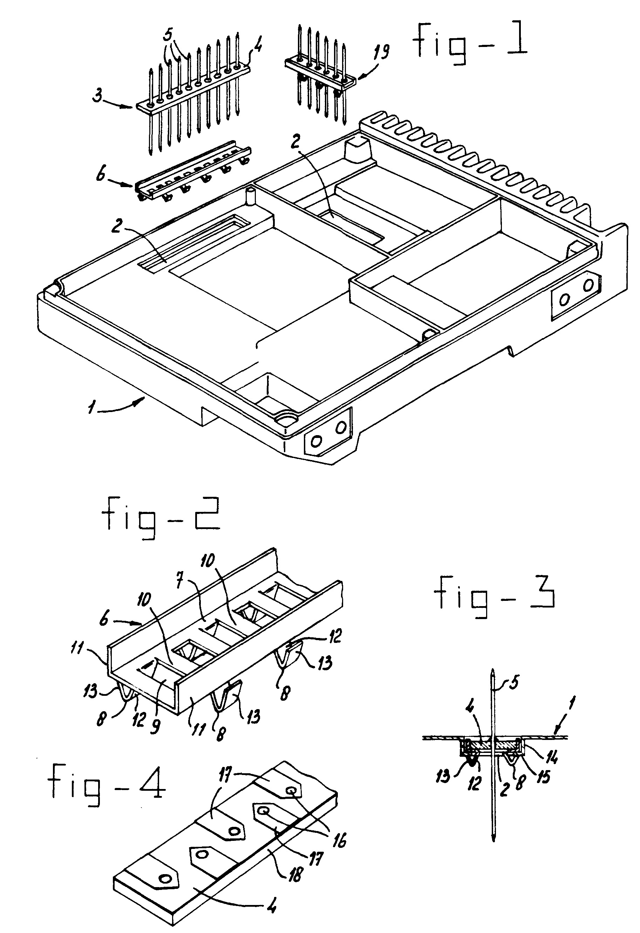

The housing 1 shown in perspective in Fig. 1 is used for car telephones. In order to prevent undesirable signal transfer between the transmitter and receiver part of such a car telephone, both the transmitter and the receiver part are accommodated in separate metal housing parts, each of which is cast from aluminium.

To electrically interconnect the transmitter and receiver parts to each other, filter connectors are used, for which the housing is provided with openings 2.

Reference number 3 indicates a filter connector according to the invention, which is shown in the unassembled state. The filter connector comprises an oblong substrate 4 of for example, alumina, on which filter elements (not shown) are formed. Contact pins 5 project on either side of substrate through holes 16 at right angles to the plane of the substrate 4. See Fig. 4. Each filter element is provided with at least one contact electrode in the form of an electrode patch 17 to which a contact pin 5 is connected, for example by soldering. The other contact electrode of the filter elements is formed by at least one common electrode 18 which is accessible on the peripheral edge of the substrate 4 for the electrical connection thereof. A substrate with filter elements of this type is known per se from EP-A-0 323 280 in the name of applicant.

A mounting frame 6 is provided for mounting of the substrate 4 and is preferably produced from sheet metal by punching, pressing or the like. In the righthand part of Fig. 1, a filter connector according to the invention, indicated by reference number 19, is shown in the assembled state. It goes without saying that, instead of the pin-shaped contact elements 5 shown, socket contact elements or combinations of pin and socket contact elements can be used.

Fig. 2 shows a part of the mounting frame 6 shown in Fig. 1, on an enlarged scale. Projecting at one side of the flat, oblong baseplate 7 are mounting lips 8 which are formed by punching out of the material of the baseplate 7. The slot-type apertures 9 thus obtained together form the feed-through aperture for the contact elements 5. The distance between the mounting lips 8 or between the apertures 9 corresponds to the pitch distance of the contact elements 5. The transverse connecting pieces 10 of the baseplate 7 increase the mechanical sturdiness of the mounting frame 6 as a whole. In order to prevent sagging in the lengthwise direction of the mounting frame, the baseplate 7 is provided with raised edges 11, as shown. Said raised edges 11 are also used for positioning of the substrate 4 and may be L-shaped to form guide slots, for example.

In the preferred embodiment of the invention the mounting lips 8 are disposed alternately on the opposite long edges of the baseplate 7, and the mounting lips 8 have a bent-over backwards shape at their free end. The part 12 of the mounting lips 8 which is connected to the flat baseplate 7 projects at an angle relative to the plane of the baseplate, in the direction towards the corresponding edge 11. The backward bent part 13 of each mounting lip 8 ends a specific distance from the baseplate 7 for the purpose of clamped fixing of one or more of the boundary edges 14 of an opening 2 in a chassis between the end of the part 13 and the baseplate 7, i.e. the side thereof from which the mounting lips 8 extend, as shown partially in cross-section in Fig. 3.

The filter connector according to the invention can now be mounted by positioning the mounting lips 8 opposite the opening 2, and by exerting a pressure force in the direction of the opening 2. Under the influence of this pressure force, the mounting lips 8 move towards each other, until the end of the backward bent part 13 engages with the flat part 15 of the boundary edge 14 of the opening 2 in the chassis, in which position the mounting lips 8 try as far as possible again, under the influence of their own resilience, to return to their initial position. Thickness differences in the chassis at the opening 2 thereof cause the mounting lips 8 to return to a greater or lesser extent to their initial position.

With the mounting frame according to the invention, thickness differences of, for example, a cast chassis can be absorbed in an effective way, while the substrate 4 of the filter connector can be mounted mechanically stress-free and electrically connected all round to the mounting frame. The at least one common electrode 18 can thereby be connected electrically and mechanically to the mounting frame 6, i.e. to the baseplate 7 and/or the raised edges 11 thereof, by means of soldering.

The number and position of the mounting lips 8, the layout of the filter substrate 4 etc. could be modified. The use of the filter connector described is, of course, not restricted to car telephones or cast housings, but can in general be employed for the relatively easy fixing of a (filter) connector in or near an aperture in a chassis without the need for separate mechanical fixing means.

## Claims

1. Filter connector (3) with latchable mounting frame (6) for mounting on a metal chassis (1) of an electrical apparatus, comprising a filter unit formed of a flat substrate (4) of electrically insulating material having a plurality of contact elements (5) of electrically conducting material which project relative to the plane of the substrate (4), and filter elements formed on the substrate (4) having one or more separate electrode patches (17) connected to the respective contact elements (5) and at least one common electrode (18) which can be connected near at least one of the edges of the substrate (4), wherein the mounting frame (6) is of electrically conducting material having a flat baseplate (7) with a feed-through aperture (9) through which the contact elements (5) extend, said substrate (4) rests with one side adjacent one side of the baseplate (7). the at least one common electrode (18) being in electrical contact with the mounting frame (6), at the other side of its baseplate (7) the mounting frame (6) being provided with resilient mounting lips (8) which project relative to the plane of the baseplate (7) for releasably latch and electrically connect the filter connector (3) in a self-latching manner on the chassis (1), in an opening (2) for the contact elements (5).

2. Filter connector according to Claim 1, wherein at their projecting free end (13) the mounting lips (8) are in a form which is bent over backwards for the clamped accommodation of a part (15) of the chassis (1) between the said other side of the baseplate (7) and the backward bent (13) end of the mounting lips (8).

3. Filter connector according to Claim 1 or 2, wherein the mounting lips (8) are disposed near at least two opposite boundary edges of the feed-through aperture (9).

4. Filter connector according to Claim 1, 2 or 3, wherein the mounting lips (8) are integral with the mounting frame (6) and are formed from the material of the baseplate (7) at the feed-through aperture (9).

5. Filter connector according to Claim 4, wherein the feed-through aperture (9) is formed by slot-type apertures which are situated corresponding to the pitch distance of the contact elements (5), the mounting lips (8) extending alternately from one and the other boundary edge of the feed-through aperture (9).

6. Filter connector according to one or more of the preceding claims, wherein for keeping the feed-through aperture (9) free, the mounting lips (8) project at an angle relative to the plane of the baseplate (7).

7. Filter connector according to one or more of the preceding claims, wherein the baseplate (7) is provided with edges (11) projecting at right angles to the said side thereof, for the accommodation of the substrate (4).

8. Mounting frame (6) to be used in combination with a filter connector according to any of the preceeding claims for the mounting of a flat substrate (4) having a plurality of contact elements (5) which project relative to the plane of the substrate (4), said mounting frame (6) having a flat baseplate (7) with a feed-through aperture (9) for receiving the contact elements (5) of said substrate (4) when resting with one side adjacent one side of the baseplate (7), characterised in that, at the other side of its baseplate (7), the mounting frame (6) is provided with resilient mounting lips (8) which project relative to the plane of the baseplate (7) for releasably latching on a chassis (1) in an opening (2) thereof.

## Patentansprüche

1. Filterverbinder (3) mit einem verriegelbaren Einbaurahmen (6) zur Montage an einem Metallgehäuse (1) einer elektrischen Vorrichtung, welche eine Filtereinheit aufweist, die von einem ebenen Substrat (4) aus elektrisch isolierendem Material gebildet ist, welches eine Mehrzahl von Kontaktelementen (5) aus elektrisch leitendem Material besitzt, welche relativ zu der Ebene des Substrats (4) vorstehen, und Filterelemente aufweist, die auf dem Substrat (4) ausgebildet sind, und die eine oder mehrere, gesonderte Elektrodenauflagen (17) haben, die mit den zugeordneten Kontaktelementen (8) verbunden sind, und wenigstens eine gemeinsame Elektrode (18) haben, welche in der Nähe wenigstens einer der Ränder des Substrats (4) angeschlossen werden kann, bei dem der Einbaurahmen (6) aus elektrisch leitendem Material besteht, eine ebene Basisplatte (7) mit einer Durchführungsöffnung (9) hat, durch die Kontaktelemente (5) verlaufen, das Substrat (4) mit einer Seite neben einer Seite der Basisplatte (7) aufliegt, die wenigstens eine gemeinsame Elektrode (18) in elektrischem Kontakt mit dem Einbaurahmen (6) ist, an der anderen Seite der Basisplatte (7) der Einbaurahmen (6) mit federnd nachgiebigen Einbaulippen (8) versehen ist, welche relativ zu der Ebene der Basisplatte (7) vorstehen und zum lösbaren, verriegelbaren Verbinden und zum elektrischen Verbinden des Filterverbinders (3) in einer selbstverriegelnden Weise an dem Gehäuse (1) in einer Öffnung (2) für die Kontaktelemente (5) dienen.

2. Filterverbinder nach Anspruch 1, bei dem an ihrem vorstehhenden freien Ende (13) die Einbaulippen (8) mit einer Form ausgelegt sind, welche nach hinten für die Klemmaufnahme eines Teils (15) des Gehäuses (1) zwischen der anderen Seite der Basisplatte (7) und des nach hinten gebogenen Teils (13) am Ende der Einbaulippen (8) umgebogen ist.

3. Filterverbinder nach Anspruch 1 oder 2, bei dem die Einbaulippen (8) in der Nähe von wenigstens zwei gegenüberliegenden Begrenzungskanten der Durchführungsöffnung (9) angeordnet sind.

4. Filterverbinder nach Anspruch 1, 2 oder 3, bei dem die Einbaulippen (8) integral mit dem Einbaurahmen (6) und aus dem Material der Basisplatte (7) an der Durchführungsöffnung (9) ausgebildet sind.

5. Filterverbinder nach Anspruch 4, bei dem die Durchführungsöffnung (9) von schlitzförmigen Öffnungen gebildet wird, welche entsprechend dem regelmäßigen Abstand der Kontaktelemente (5) angeordnet sind, und die Einbaulippen (8) wechselweise von der einen oder der anderen Begrenzungskante der Durchführungsöffnung (9) ausgehen.

6. Filterverbinder nach einem oder mehreren der vorangehenden Ansprüche, bei dem zum Freihalten der Durchführungsöffnung (9) die Einbaulippen (8) unter einem Winkel relativ zu der Ebene der Basisplatte (7) vorstehen.

7. Filterverbinder nach einem oder mehreren der vorangehenden Ansprüche, bei dem die Basisplatte (7) mit Rändern (11) derart versehen ist, daß diese rechtwinklig zu der Seite hiervon zur Aufnahme des Substrats (4) vorstehen.

8. Einbaurahmen zum bestimmungsgemäßen Einsatz in Kombination mit einem Filterverbinder nach einem der vorangehenden Ansprüche zur Montage eines ebenen Substrats (4), welche eine Mehrzahl von Kontaktelementen (5) hat, die relativ zu der Ebene des Substrat (4) vorstehen, der Einbaurahmen (6) eine ebene Basisplatte (7) mit einer Durchführungsöffnung (9) zur Aufnahme der Kontaktelemente (5) des Substrats (4) hat, wenn diese mit einer benachbarten Seite auf einer Seite der Basisplatte (7) aufliegt, dadurch gekennzeichnet, daß an der anderen Seite seiner Basisplatte (7) der Einbaurahmen (6) mit federnd nachgiebigen Einbaulippen (8) versehen ist, welche relativ zu der Ebene der Basisplatte (7) zum lösbaren Verriegeln an einem Gehäuse (1) in einer Öffnung (2) desselben vorstehen.

## Revendications

1. Un connecteur à filtre (3) et à embase de montage verrouillable (6) pour montage sur un châssis métallique (1) d'un appareil électrique, comprenant une unité de filtre formée d'un substrat plan (4) en un matériau électriquement isolant présentant une pluralité d'éléments de contact (5) en un matériau électriquement conducteur de l'électricité qui font saillie par rapport au plan du substrat (4), et des éléments de filtre formés sur le substrat (4) présentant une ou plusieurs pastilles d'électrode séparées (17) reliées aux éléments de contact respectifs (5) et au moins une électrode commune (18) susceptible d'être raccordée à proximité de l'un au moins des bords du substrat (4), dans lequel l'embase de montage (6) est réalisée en un matériau conducteur de l'électricité présentant une plaque de base plane (7) munie d'une ouverture de traversée (9) à travers laquelle s'étendent les éléments de contact (5), ledit substrat (4) reposant par l'une de ses faces adjacente à l'une des faces de la plaque de base (7), ladite électrode commune (18) étant en contact électrique avec l'embase de montage (6), l'embase de montage (6) étant munie, sur l'autre face de sa plaque de base (7), de lèvres de montage élastiques (8) faisant saillie par rapport au plan de la plaque de base (7) pour verrouiller de façon amovible et raccorder électriquement le connecteur à filtre (3) à auto-vérouillage sur le châssis (1), dans une ouverture (2) pour les éléments de contact (5).

2. Connecteur à filtre selon la revendication 1, dans lequel les lèvres de montage (8), à leur extrémité libre en saillie (13), présentent une forme repliée vers l'arrière afin de loger, en la pinçant, une partie (15) du châssis (1) entre ladite autre face de la plaque de base (7) et l'extrémité repliée vers l'arrière (13) des lèvres de montage (8).

3. Connecteur à filtre selon la revendication 1 ou 2, dans lequel les lèvres de montage (8) sont disposées à proximité d'au moins deux bords de délimitation opposés de l'ouverture de traversée (9).

4. Connecteur à filtre selon la revendication 1, 2 ou 3, dans lequel les lèvres de montage (8) sont monobloc avec l'embase de montage (6) et sont formés à partir du matériau de la plaque de base (7) à l'ouverture de traversée (9).

5. Connecteur à filtre selon la revendication 4, dans lequel l'ouverture de traversée (9) est formée par des ouvertures du type à fente qui sont situées à une distance correspondant au pas des éléments de contact (5), les lèvres de montage (8) s'étendant en alternance de l'un ou de l'autre bord de délimitation de l'ouverture de traversée (9).

6. Connecteur à filtre selon l'une ou plusieurs des revendications précédentes, dans lequel, afin de maintenir libre l'ouverture de traversée (9), les lèvres de montage (8) font saillie en formant un angle avec le plan de la plaque de base (7).

7. Connecteur à filtre selon une ou plusieurs des revendications précédentes, dans lequel la plaque de base (7) est munie de rebords (11) faisant saillie à angle droit par rapport à ladite face de la plaque de base, pour loger le substrat (4).

8. Embase de montage (6) destinée à être utilisée avec un connecteur à filtre selon l'une quelconque des revendications précédentes, pour le montage d'un substrat plan (4) présentant une pluralité d'éléments de contact (5) qui font saillie par rapport au plan du substrat (4), ladite embase de montage (6) présentant une plaque de base plane (7) avec une ouverture de traversée (9) destinée à recevoir les éléments de contact (5) dudit substrat (4), quand l'une des faces de ce dernier repose adjacente à l'une des faces de la plaque de base (7), caractérisé en ce que, sur l'autre face de sa plaque de base (7), l'embase de montage (6) est munie de lèvres de montage élastiques (8) en saillie par rapport au plan de la plaque de base (7) pour assurer un verrouillage amovible sur un châssis (1) dans une ouverture (2) de ce dernier.
